# EUROPÄISCHE PATENTSCHRIFT

(11) **EP 3 271 943 B1**
(45) Veröffentlichungstag und Bekanntmachung des Hinweises auf die Patenterteilung: **15.01.2020**
(21) Anmeldenummer: 16716525.7
(22) Anmeldetag: 07.04.2016
(51) Int. Cl.: H01L 25/07, H01L 25/16, H01L 25/18, H01L 25/00, H01L 23/40, H01L 21/56, H01L 23/31, H01L 23/367, H01L 23/34, H01L 23/373, H01L 23/482, H01L 23/498, H01L 23/00, H01L 23/538

(54) **LEISTUNGSMODUL SOWIE VERFAHREN ZUM HERSTELLEN EINES LEISTUNGSMODULS**
POWER MODULE AND METHOD FOR PRODUCING A POWER MODULE
MODULE DE PUISSANCE ET PROCÉDÉ DE FABRICATION D'UN MODULE DE PUISSANCE

(30) Priorität: 06.05.2015 DE 102015208348
(43) Veröffentlichungstag der Anmeldung: 24.01.2018
(73) Patentinhaber: Siemens Aktiengesellschaft, 80333 München (DE)
(72) Erfinder: WEIDNER, Karl, 81245 München (DE); KRIEGEL, Kai, 81739 München (DE)
(86) Internationale Anmeldenummer: PCT/EP2016/057567
(87) Internationale Veröffentlichungsnummer: WO 2016/177528

(56) Entgegenhaltungen:
- DE-A1- 19 633 542
- JP-A- 2003 051 573

## Beschreibung

Die Erfindung betrifft ein Leistungsmodul mit einer Leistungseinheit und einer Ansteuereinheit zum Ansteuern der Leistungseinheit. Die Erfindung betrifft außerdem ein Verfahren zum Herstellen eines Leistungsmoduls.

Leistungsmodule beziehungsweise Leistungshalbleitermodule sind bereits aus dem Stand der Technik bekannt und können als Stromrichter, beispielsweise Wechselrichter oder Gleichrichter, ausgestaltet sein. Solche Leistungsmodule weisen dabei Chips, also Leistungshalbleiterbauelemente beziehungsweise Leistungsbauelemente, beispielsweise Transistoren, IGBTs oder Dioden, auf, welche üblicherweise auf einem keramischen Substrat angeordnet und mit diesem, beispielsweise durch Löten, stoffschlüssig verbunden sind. Das mit den Leistungsbauelementen bestückte Substrat ist in der Regel in einem Gehäuse angeordnet. Zur Kontaktierung der Leistungsbauelemente werden üblicherweise Bondverbindungen verwendet, welche von einer Kontaktfläche des Chips zu einer Anschlussfläche auf dem Substrat geführt sind. Bei einem solchen Aufbau aus elektrischen Bauelementen, welche mittels Bonddrähten elektrisch verschaltet beziehungsweise verbunden sind, ergibt sich der Nachteil, dass einerseits die Bondverbindungen, insbesondere bei Erschütterungen sowie thermomechanischen Belastungen, leicht brechen können und andererseits solche Leistungsmodule eine sehr hohe Induktivität aufweisen.

Aus der DE 196 33 542 A1 und aus der JP 2003 051573 A sind jeweils Leistungsmodule mit Leistungseinheit und Ansteuereinheit bekannt.

Eine weitere große Herausforderung bei der Ausgestaltung von Leistungsmodulen stellt die notwendige Abfuhr der durch die Leistungsbauelemente im Betrieb produzierten Wärme dar, insbesondere da die elektrischen Bauelemente immer kleiner werden. Dazu wird im Stand der Technik in der Regel entweder ein aufwändiges thermisches Management durchgeführt oder die Leistungsfähigkeit der Leistungsmodule aufgrund begrenzter Möglichkeiten zur Wärmeabfuhr begrenzt.

Es ist Aufgabe der vorliegenden Erfindung, ein besonders zuverlässiges und kompaktes Leistungsmodul zu realisieren, bei welchem eine Abwärme besonders gut und effizient abgeführt werden kann.

Diese Aufgabe wird durch ein Leistungsmodul sowie ein Verfahren gemäß den unabhängigen Patentansprüchen gelöst. Vorteilhafte Ausführungsformen der Erfindung sind Gegenstand der abhängigen Patentansprüche.

Ein erfindungsgemäßes Leistungsmodul umfasst alle Merkmale des Anspruchs 1. Es umfasst eine Leistungseinheit sowie eine Ansteuereinheit zum Ansteuern der Leistungseinheit. Die Leistungseinheit weist einen Kühlkörper, zumindest ein auf dem Kühlkörper angeordnetes Leistungsbauelement und eine den Kühlkörper und das zumindest eine Leistungsbauelement bedeckende Isolierschicht auf. Dabei ist eine Unterseite der Leistungseinheit durch eine Unterseite des Kühlkörpers gebildet und eine Oberseite der Leistungseinheit durch zumindest eine, mit dem zumindest einen Leistungsbauelement thermisch und/oder elektrisch gekoppelte Kontaktfläche sowie eine die zumindest eine Kontaktfläche umgebende Oberfläche der Isolierschicht gebildet. Die Ansteuereinheit weist zumindest ein, zu der zumindest einen Kontaktfläche der Leistungseinheit korrespondierendes Kontaktelement auf, welches durch Anordnen der Ansteuereinheit auf der Oberseite der Leistungseinheit anliegend an der zumindest einen Kontaktfläche der Leistungseinheit zum elektrischen und/oder thermischen Kontaktieren des zumindest einen Leistungsbauelements angeordnet ist.

Das Leistungsmodul kann beispielsweise als ein Stromrichter ausgestaltet sein. Das zumindest eine Leistungsbauelement, welches beispielsweise als ein Leistungs-MOSFET oder als ein IGBT ausgestaltet sein kann, ist auf dem Kühlkörper angeordnet und mit dem Kühlkörper zum Abführen der durch das zumindest eine Leistungsbauelement im Betrieb produzierten Abwärme thermisch gekoppelt. Insbesondere ist das zumindest ein Leistungsbauelement mit der Oberseite des Kühlkörpers verbunden.

Der das Leistungsbauelement umgebende Bereich auf der Oberseite des Kühlkörpers sowie das Leistungsbauelement selbst sind von der Isolierschicht, insbesondere vollständig, bedeckt. Die Isolierschicht kann beispielsweise eine Vergussmasse, z.B. ein sogenanntes Mould Compound, und/oder eine Isolierfolie umfassen. Zum elektrischen und/oder thermischen Kontaktieren des zumindest einen Leistungsbauelement kann beispielsweise ein Anschluss an dem zumindest einen Leistungsbauelement mit einem elektrischen und/oder thermischen Leitelement gekoppelt sein. Das elektrische und/oder thermische Leitelement kann dabei durch die Isolierschicht hindurch an die Oberfläche der Isolierschicht geführt sein, sodass an der Oberseite der Leistungseinheit lediglich die Kontaktflächen des Leitelementes freigelegt sind. Das Leitelement kann beispielsweise Kupfer aufweisen. Anders ausgedrückt, ist das Leistungsbauelement in die Isolierschicht eingebettet, wobei an der Oberseite der Leistungseinheit nur die Oberfläche der Isolierschicht sowie die zumindest eine Kontaktfläche, welche auch als Funktionsinsel bezeichnet wird, sichtbar ist. Das zumindest eine Leistungsbauelement ist also durch die Isolierschicht und den Kühlkörper voll gekapselt. Die zumindest eine Kontaktfläche befindet sich dabei insbesondere an einer definierten Position auf der Oberseite der Leistungseinheit, insbesondere direkt über dem in die Isolierschicht eingebetteten Leistungsbauelement.

Zu der zumindest einen Kontaktfläche, insbesondere zu der definierten Position der zumindest einen Kontaktfläche, korrespondierend weist die Ansteuereinheit das zumindest eine Kontaktelement auf. Sobald also die Ansteuereinheit bestimmungsgemäß auf der Oberseite der Leistungseinheit angeordnet ist, berührt das zumindest ein Kontaktelement die Kontaktfläche der Leistungseinheit und stellt dadurch den thermischen und/oder elektrischen Kontakt zu dem zumindest einen Leistungsbauelement her.

Bei dem erfindungsgemäßen Leistungsmodul können also in vorteilhafter Weise die Leistungseinheit und die Ansteuereinheit getrennt ausgeführt sein und erst in einem späteren Prozessschritt, beispielsweise zum Bereitstellen des kompletten Leistungsmoduls, durch Anordnen der Ansteuereinheit auf der Oberseite der Leistungseinheit vereint werden. Dadurch kann beispielsweise die Leistungseinheit leicht standardisiert werden, während die Ansteuereinheit an die jeweiligen Applikationen angepasst werden kann. Somit kann das Leistungsmodul besonders kostengünstig hergestellt werden.

Durch das Einbetten des zumindest einen Leistungsbauelementes in die Isolierschicht und das Anordnen der Ansteuereinheit auf der Oberseite der Leistungseinheit ist das Leistungsmodul insbesondere gehäuselos verwendbar. Mit anderen Worten bedeutet dies, dass die Leistungseinheit und die Ansteuereinheit nicht in ein separates, gegenständliches Gehäuse integriert werden müssen. Somit kann ein Leistungsmodul mit einem besonders kleinen Volumen und mit einem besonders geringen Gewicht bereitgestellt werden.

Besonders bevorzugt sind die zumindest eine Kontaktfläche und die Oberfläche der Isolierschicht bündig angeordnet und somit durch die Oberfläche der Isolierschicht und die zumindest eine Kontaktfläche eine ebene Oberseite der Leistungseinheit gebildet. Anders ausgedrückt ist die Oberseite der Leistungseinheit als eine glatte Ebene aus Isolierschichtoberfläche und Funktionsinsel ausgebildet. Dabei ist unter einer glatten beziehungsweise ebenen Fläche eine Fläche zu verstehen, welche im Rahmen von Messtoleranzen und Fertigungstoleranzen als solche bezeichnet werden kann. Durch die ebene Oberseite der Leistungseinheit ist die Leistungseinheit besonders kompakt ausgestaltet.

Vorzugsweise ist auf die Oberseite des Kühlkörpers zumindest eine elektrische Leiterbahn aufgebracht, die zumindest eine Leiterbahn über ein elektrisches Verbindungselement elektrisch mit dem zumindest einen Leistungsbauelement verbunden und das elektrische Verbindungselement von der Isolierschicht bedeckt. Dabei ist das elektrische Verbindungselement vorzugsweise eine elektrisch leitende Fläche, beispielsweise eine Kupferfläche, welche mittels eines planaren Aufbau- und Verbindungsprozesses hergestellt ist. Ein solcher planarer Aufbau- und Verbindungsprozess kann beispielsweise eine von Siemens entwickelte Technologie namens SiPLIT (Siemens Planar Interconnect Technology) sein. Dadurch dass das elektrische Verbindungselement ebenfalls von der Isolierschicht bedeckt beziehungsweise umhüllt ist, ist das elektrische Verbindungselement besonders gut vor äußeren Einflüssen, beispielsweise Erschütterungen oder Umwelteinflüssen, geschützt. Somit kann eine zuverlässige elektrische Verbindung des Leistungsbauelementes zu der zumindest einen Leiterbahn gewährleistet werden. Außerdem kann das elektrische Verbindungselement beispielsweise als ein Shunt-Widerstand ausgestaltet sein, sodass zusätzlich eine Strommessung in das Leistungsmodul integriert ist. Somit kann ein besonders zuverlässiges Leistungsmodul bereitgestellt werden und eine Kühlung des Leistungsmoduls optimiert werden.

Es kann auch vorgesehen sein, dass das zumindest eine Leistungsbauelement innerhalb der Leistungseinheit auf der Oberseite des Kühlkörpers mittels einer sogenannten Flip-Chip-Technologie aufgebracht ist. Die Flip-Chip-Montage ist ein Verfahren der Aufbau- und Verbindungstechnik zur Kontaktierung des zumindest einen Leistungsbauelementes mittels sogenannter Kontaktierhügel. Dabei wird der Chip direkt, also ohne weitere Anschlussdrähte beziehungsweise ohne das elektrische Verbindungselement, mit seiner aktiven Kontaktierungsseite beziehungsweise einem Anschluss nach unten, also zum Kühlkörper hin, montiert. Dies führt zu besonders geringen Abmessungen beziehungsweise Dimensionen und kurzen Leiterlängen, wodurch das Leistungsmodul eine besonders geringe Modulinduktivität aufweist.

Gemäß einer bevorzugten Ausführungsform ist zwischen dem zumindest einem Leistungsbauelement und der Oberseite des Kühlkörpers nur eine Verbindungsschicht zum stoffschlüssigen Verbinden des zumindest einen Leistungsbauelementes mit der Oberseite des Kühlkörpers angeordnet. Eine solche Verbindungsschicht kann beispielsweise eine Lötschicht oder eine Sinterschicht sein. Dabei ist kein gegenständliches Bauteil, insbesondere keine Leiterplatte oder kein Keramiksubstrat, zwischen dem zumindest einen Leistungsbauelement und der Oberseite des Kühlkörpers angeordnet. Somit kann eine im Betrieb des zumindest einen Leistungsbauelementes entstehende Wärme besonders gut und effizient an den Kühlkörper abgeführt werden.

Alternativ dazu kann das zumindest eine Leistungsbauelement unmittelbar beziehungsweise direkt auf der Oberseite des Kühlkörpers angeordnet sein und durch Aufbringen eines ständigen Druckes auf die Oberfläche der Isolierschicht und/oder auf die zumindest eine Kontaktfläche kraftschlüssig mit der Oberseite des Kühlkörpers verbunden werden. Gemäß diesem Ausführungsbeispiel wird das Leistungsbauelement also lediglich durch Aufbringen des ständigen Druckes auf die Oberseite des Kühlkörpers gepresst, sodass auf eine Lot- oder Sinterschicht verzichtet werden kann. Anders ausgedrückt bedeutet dies, dass eine Bauelementkontaktierung lot- und sinterfrei möglich ist. Diese Druckkontakttechnik vermeidet insbesondere bei Vibrationen beziehungsweise Schwingungen unter Betriebsbedingungen ein Abreißen der Leistungsbauelemente beziehungsweise Chips von der Oberseite des Kühlkörpers. Dies ist insbesondere bei Hochstromapplikationen vorteilhaft. Bei einer elektrischen Kontaktierung des zumindest einen Leistungsbauelementes mittels der Flip-Chip-Technologie ist das zumindest eine Leistungsbauelement unmittelbar auf einer Kontaktfläche, beispielsweise der Leiterbahn, auf der Oberseite des Kühlkörpers angeordnet und dort unter dem ständigen Druck angepresst.

Es erweist sich als vorteilhaft, wenn das zumindest eine Kontaktelement der Ansteuereinheit als ein Kühlelement und/oder als ein elektrisches Druckkontaktelement ausgebildet ist, wobei der Druck zum kraftschlüssigen Verbinden durch das Kühlelement und/oder durch das Druckkontaktelement beim Anordnen auf der zumindest einen Kontaktfläche zum Kontaktieren des zumindest einen Leistungsbauelementes aufgebracht ist. Ein solches Kühlelement kann beispielsweise ein Kühlstempel gegebenenfalls in Verbindung mit einem Wärmerohr, einer sogenannten Heatpipe, zum Abführen der Wärme sein. Somit kann sowohl das zumindest eine Leistungsbauelement besonders zuverlässig befestigt werden als auch eine beidseitige Kühlung des zumindest einen Leistungsbauelementes, nämlich über den Kühlkörper und den Kühlstempel, realisiert werden. Zusätzlich kann die Isolierschicht elastisch sein, sodass mittels des Kühlelements beziehungsweise einer Kühlstruktur besonders gut ein mechanischer Druck auf das zumindest eine Leistungsbauelement ausgeübt werden kann. Hierdurch kann zudem die Zuverlässigkeit des Leistungsmoduls durch eine thermomechanische Entkopplung gesteigert werden.

Das Druckkontaktelement kann beispielsweise ein an der Ansteuereinheit vorstehender oder in die Ansteuereinheit integrierter, vorgeformter Kontaktblock, beispielsweise ein Kupferblock, sein, welcher durch Anordnen der Ansteuereinheit auf der Leistungseinheit einen ständigen Druck auf die Kontaktfläche ausübt und damit das zumindest eine Leistungsbauelement besonders gut fixiert. Auch kann das Druckkontaktelement als ein Federkontaktelement ausgestaltet sein.

Eine Weiterbildung der Erfindung sieht vor, dass der Kühlkörper als eine mit einem elektrisch isolierenden, thermisch leitfähigen Material beschichtete Kühlplatte ausgebildet ist, wobei eine Oberfläche des elektrisch isolierenden, thermisch leitfähigen Materials die Oberseite des Kühlkörpers ausbildet. Die Kühlplatte kann beispielsweise eine Aluminiumplatte sein, welche beispielsweise mit Aluminiumnitrid oder Siliziumnitrid als das elektrisch isolierende, thermisch leitfähige Material beschichtet ist. Aluminiumnitrid und Siliziumnitrid weisen den Vorteil einer besonders hohen thermischen Leitfähigkeit auf und sind damit besonders gut zum Kühlen des Leistungsmoduls geeignet. Das elektrisch isolierende, thermisch leitfähige Material kann beispielsweise als eine Platte, eine Folie oder durch Aufsprühen auf die Kühlplatte aufgebracht werden. Auf dieses elektrisch isolierende, thermisch leitfähige Material ist dann beispielsweise die zumindest
eine Leiterbahn und/oder die Verbindungsschicht des zumindest einen Leistungsbauelementes, also beispielsweise das Lot oder die Sinterpaste, aufgebracht.

In einer Ausgestaltung der Erfindung umfasst die Ansteuereinheit eine Leiterplatte und zumindest ein Bauelement zum Ansteuern des zumindest einen Leistungsbauelementes der Leistungseinheit. Das zumindest eine Bauelement kann beispielsweise ein Treiberbaustein und/oder eine Logikschaltung und/oder eine Steuereinrichtung sein. Das zumindest eine Bauelement der Ansteuereinheit kann mit dem Kontaktelement verbunden sein, sodass das zumindest eine Bauelement beim Anordnen der Ansteuereinheit auf der Leistungseinheit mit dem Leistungsbauelement der Leistungseinheit, beispielsweise zum Ansteuern des zumindest einen Leistungsbauelementes, elektrisch verbunden ist.

Eine weitere Ausführungsform sieht vor, dass die Leiterplatte zumindest ein Sensorelement zum Erfassen einer physikalischen Eigenschaft des Leistungsmoduls aufweist. Das zumindest eine Sensorelement kann beispielsweise ein Temperatursensor zur Messung einer Temperatur des Leistungsmoduls sein. Das zumindest eine Sensorelement ist insbesondere dazu ausgelegt, die erfasste physikalische Eigenschaft, beispielsweise die erfassten Temperaturen, beispielsweise an eine übergeordnete Steuereinheit, zu übertragen.

Es kann vorgesehen sein, dass die Leiterplatte zumindest zwei Schichten aufweist, und das zumindest eine Bauelement und/oder das zumindest eine Sensorelement zwischen den zumindest zwei Schichten angeordnet ist. Anders ausgedrückt ist die Leiterplatte beispielsweise als eine sogenannte Multilayer-Leiterplatte ausgestaltet, wobei das zumindest eine Bauelement und/oder das zumindest eine Sensorelement in einer Aussparung zwischen den zwei Schichten angeordnet ist und somit durch die beiden Schichten vollständig umschlossen ist. Dies bedeutet, dass das zumindest eine Bauelement und/oder das zumindest eine Sensorelement in die Leiterplatte eingebettet ist. Innerhalb dieser Leiterplatte und/oder auf der Leiterplatte können beispielsweise die Treiberanschlüsse und die Lastanschlüsse für das zumindest eine Leistungsbauelement der Leistungseinheit vorgesehen sein. Daraus ergibt sich der Vorteil, dass kein Zusatzaufwand zur Herstellung der Lastanschlüsse betrieben werden muss und die mit dem Herstellungsprozess der Lastanschlüsse einhergehenden Unzuverlässigkeiten vermieden werden können.

Eine vorteilhafte Ausführungsform der Erfindung sieht vor, dass eine erste der zumindest zwei Schichten direkt auf die Oberseite der Leistungseinheit abgeschieden ist und mit der Oberseite der Leistungseinheit stoffschlüssig verbunden ist, das zumindest eine Bauelement und/oder das zumindest eine Sensorelement auf der ersten Schicht angeordnet ist und eine zweite der zumindest zwei Schichten direkt auf der ersten Schicht abgeschieden ist, wobei die zweite Schicht das zumindest eine Bauelement und/oder das zumindest eine Sensorelement bedeckt. Anders ausgedrückt ist das zumindest eine Bauelement und/oder das zumindest eine Sensorelement der Ansteuereinheit zwischen den zwei Schichten eingebettet und die gesamte Ansteuereinheit durch das stoffschlüssige Verbinden der ersten Schicht mit der Oberseite der Leistungseinheit stoffschlüssig mit der Leistungseinheit verbunden. Die einzelnen Schichten können beispielsweise als sogenannte Prepreg-Schichten auflaminiert werden. Durch das direkte Aufbringen der Schichten auf die Oberseite der Leistungseinheit und das damit einhergehende stoffschlüssige Verbinden der Ansteuereinheit mit der Leistungseinheit wird in vorteilhafter Weise ein besonders kompaktes, hochintegriertes und zuverlässiges Leistungsmodul realisiert.

Es kann vorgesehen sein, dass die Ansteuereinheit, insbesondere die Leiterplatte, an einer Unterseite der Ansteuereinheit das zumindest eine Kontaktelement aufweist und das zumindest eine Kontaktelement durch Anordnen der Ansteuereinheit auf der Oberseite der Leistungseinheit anliegend an der zumindest eine Kontaktfläche zum elektrischen und/oder thermischen Kontaktieren des zumindest einen Leistungsbauelements ausgebildet ist. Die Ansteuereinheit in Form von der Leiterplatte kann beispielsweise eine vorgefertigte Leiterplatte sein, welche beispielsweise über Federkontakte oder Schnappverbindungen an der Oberseite der Leistungseinheit angepresst ist. Das zumindest eine Kontaktelement kann beispielsweise ein Kupferblock sein, welcher bereichsweise in die Leiterplatte integriert ist und/oder durchgängig über eine gesamte Dicke der Ansteuereinheit in der Ansteuereinheit angeordnet ist. Alternativ oder zusätzlich zum Aufpressen kann das zumindest eine Kontaktelement mit der zumindest einen korrespondierenden Kontaktflächen verlötet werden, und damit die Ansteuereinheit stoffschlüssig mit der Leistungseinheit verbunden werden.

Auch kann es vorgesehen sein, dass die Ansteuereinheit zumindest eine zu der Kontaktfläche korrespondierende durchgängige Aussparung aufweist, welche beim Anordnen der Ansteuereinheit auf der Oberseite der Leistungseinheit fluchtend zu der zumindest einen Kontaktfläche angeordnet ist, wobei das zumindest eine Kontaktelement zum Kontaktieren des zumindest einen Leistungsbauelementes in der durchgängigen Aussparung angeordnet ist. Die Ansteuereinheit in Form von der Leiterplatte kann eine vorgefertigte Leiterplatte sein, welche die Aussparungen, insbesondere über eine Dicke der Leiterplatte, aufweist. Beim Anordnen der vorgefertigten Leiterplatte auf der Leistungseinheit ist dabei die zumindest eine Aussparung derart über der zumindest einen Kontaktfläche angeordnet, dass die Kontaktfläche über die darüber liegende Aussparung zugänglich ist. Es kann aber auch vorgesehen sein, dass die Leiterplatte in den Schichten direkt auf die Oberfläche der Isolierschicht der Leistungseinheit abgeschieden ist, wobei die zumindest eine Kontaktfläche beim Abscheiden nicht von den Schichten der Leiterplatte bedeckt wird. Anders ausgedrückt kann der Ort oberhalb der zumindest einen Kontaktfläche beziehungsweise oberhalb des zumindest einen Leistungsbauelementes ausgespart bleiben. Um eine thermische und/oder elektrische Kontaktierung herzustellen, kann durch die Leiterplatte hindurch beziehungsweise durch die Aussparung der Leiterplatte hindurch durchkontaktiert werden, indem das zumindest eine Kontaktelement in der Aussparung angeordnet wird.

Insgesamt wird also durch die Kombination aus Leistungseinheit und Ansteuereinheit ein hochkompaktes, hochintegriertes und intelligentes Leistungsmodul gebildet, dessen Unterseite durch die Unterseite des Kühlkörpers gebildet ist und dessen Oberseite durch eine Oberseite der Ansteuereinheit gebildet ist. Das Leistungsmodul kann beispielsweise als ein quaderförmiger, hochkompakter Block ausgestaltet sein, welcher beispielsweise lediglich an der Oberseite der Ansteuereinheit elektrische und/oder thermische Kontaktelemente zum Kontaktieren der Leistungseinheit aufweist. Die übrigen Oberflächenbereiche des Leistungsmoduls sind elektrisch isoliert, wodurch das gesamte Leistungsmodul gehäuselos, beispielsweise als Stromrichter, verwendbar ist.

Die Erfindung betrifft außerdem ein Verfahren zum Herstellen eines Leistungsmoduls mit einer Leistungseinheit und einer Ansteuereinheit zum Ansteuern der Leistungseinheit, umfassend alle Merkmale des Anspruchs 12. Bei dem Verfahren wird auf einem Kühlkörper der Leistungseinheit ein Leistungsbauelement angeordnet und der Kühlkörper und das zumindest eine Leistungsbauelement mit einer Isolierschicht bedeckt. Dabei wird eine Unterseite der Leistungseinheit durch eine Unterseite des Kühlkörpers gebildet und eine Oberseite der Leistungseinheit durch zumindest eine, mit dem zumindest einen Leistungsbauelement thermisch und/oder elektrisch gekoppelte Kontaktfläche sowie eine die zumindest eine Kontaktfläche umgebende Oberfläche der Isolierschicht gebildet. Zumindest ein zu der zumindest einen Kontaktfläche der Leistungseinheit korrespondierendes Kontaktelement der Ansteuereinheit wird durch Anordnen der Ansteuereinheit auf der Oberseite der Leistungseinheit anliegend an der zumindest einen Kontaktfläche der Leistungseinheit zum elektrischen und/oder thermischen Kontaktieren des zumindest einen Leistungsbauelementes angeordnet.

Die mit Bezug auf das erfindungsgemäße Leistungsmodul vorgestellten Ausführungsformen und deren Vorteile gelten entsprechend für das erfindungsgemäße Verfahren.

Im Folgenden wird die Erfindung nun anhand eines bevorzugten Ausführungsbeispiels wie auch unter Bezugnahme auf die beigefügten Zeichnungen näher erläutert.

Es zeigen:
- FIG 1: eine schematische Darstellung einer Ausführungsform eines erfindungsgemäßen Leistungsmoduls und
- FIG 2: eine schematische Darstellung einer Leistungseinheit einer Ausführungsform eines erfindungsgemäßen Leistungsmoduls in einer Draufsicht.

In den Figuren sind gleiche sowie funktionsgleiche Elemente mit den gleichen Bezugszeichen versehen.

Bei dem im Folgenden erläuterten Ausführungsbeispiel handelt es sich um eine bevorzugte Ausführungsform der Erfindung. Bei dem Ausführungsbeispiel stellen dabei die beschriebenen Komponenten der Ausführungsform jeweils einzelne, unabhängig voneinander zu betrachtende Merkmale der Erfindung dar, welche die Erfindung auch jeweils unabhängig voneinander weiterbilden und damit auch einzeln oder in einer anderen als der gezeigten Kombination als Bestandteil der Erfindung anzusehen sind. Des Weiteren ist die beschriebene Ausführungsform auch durch weitere der bereits beschriebenen Merkmale der Erfindung ergänzbar.

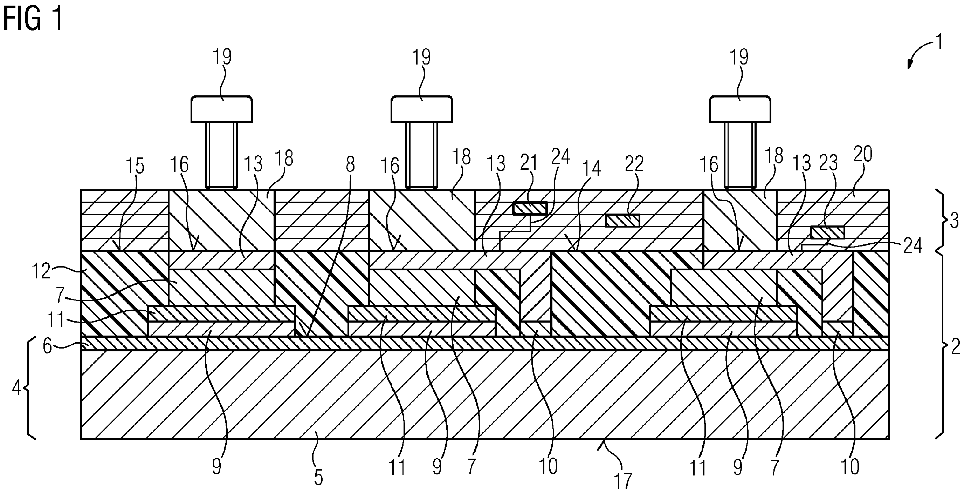

FIG 1 zeigt ein Leistungsmodul 1 mit einer Leistungseinheit 2 und einer Ansteuereinheit 3 zum Ansteuern der Leistungseinheit 2. Das Leistungsmodul 1 kann beispielsweise als ein AC/DC-Wandler oder ein DC/DC-Wandler ausgestaltet sein. Die Leistungseinheit 2 umfasst einen Kühlkörper 4, welcher eine Kühlplatte 5 sowie ein die Kühlplatte 5 bedeckendes elektrisch isolierendes, thermisch leitfähiges Material 6 aufweist. Das elektrisch isolierende, thermisch leitfähige Material 6 muss insbesondere nur dann vorgesehen sein, wenn die Kühlplatte 5 selbst aus einem elektrisch leitfähigen Material, beispielsweise Aluminium, gefertigt ist. Das elektrisch isolierende, thermisch leitfähige Material 6 kann beispielsweise Siliziumnitrid, Aluminiumnitrid oder ein wärmeleitendes, elektrisch isolierendes organisches Material sein, und als Platte, Folie oder durch Aufsprühen auf die Kühlplatte 5 aufgebracht sein. Eine Oberfläche des elektrisch isolierenden, thermisch leitfähigen Materials 6 bildet eine Oberseite 8 des Kühlkörpers 4.

Der Kühlkörper 4 dient hier zum Kühlen mehrerer Leistungsbauelemente 7 der Leistungseinheit 2, welche beispielsweise als IGBTs oder als ein Leistungstransistoren ausgestaltet sein können und welche auf der Oberseite 8 des Kühlkörpers 4 angeordnet und mit dieser verbunden werden. Zum stoffschlüssigen Verbinden der Leistungsbauelemente 7 mit der Oberseite 8 des Kühlkörpers 4 können strukturierte Metallflächen 9, 10 auf die Oberseite 8 des Kühlkörpers 4 aufgebracht werden. Auf die Metallflächen 9 kann zum stoffschlüssigen Verbinden der Leistungsbauelemente 7 eine Verbindungsmasse 11, beispielsweise Lot oder eine Sinterpaste, aufgebracht sein, wobei die Metallflächen 9 und die Verbindungsmasse 11 eine Verbindungsschicht bilden, welche direkt zwischen der Oberseite 8 des Kühlkörpers 4 und den Leistungsbauelementen 7 angeordnet ist. Zwischen der Oberseite 8 des Kühlkörpers 4 und den Leistungsbauelementen 7 ist also lediglich die Verbindungsschicht 9, 11 vorgesehen. Dabei ist kein weiteres gegenständliches Bauelement, insbesondere keine Leiterplatte oder kein Keramiksubstrat, zwischen den Leistungsbauelementen 7 und der Oberseite 8 des Kühlkörpers 4 angeordnet.

Es kann auch vorgesehen sein, dass die Leistungsbauelemente 7 unmittelbar, also ohne Bereitstellen der Verbindungsschicht 9, 11, auf der Oberseite 8 des Kühlkörpers 4 angeordnet sind und mit der Oberseite 8 des Kühlkörpers 4 unter ständigem Druck kraftschlüssig verbunden sind. Dann kann eine lot- beziehungsweise sinterfreie Leistungseinheit 2 bereitgestellt werden.

Die Metallflächen 10 sind beispielsweise als Leiterbahnen ausgestaltet, mit welchen die Leistungsbauelemente 7, beispielsweise zum Verschalten der Leistungsbauelemente 7 untereinander, elektrisch verbunden werden. Die Leistungsbauelemente 7 können beispielsweise über elektrische Verbindungselemente 13 mit den Leiterbahnen 10 elektrisch verbunden sein.

Die Leistungsbauelemente 7 sowie die Oberseite 8 des Kühlkörpers 4 sind von einer Isolierschicht 12 bedeckt. Die Isolierschicht 12 kann dabei in mehreren Schichten abgeschieden werden und beispielsweise eine sogenannte Mouldmasse, also eine Vergussmasse, und/oder eine Isolierfolie umfassen. Nach Aufbringen einer ersten Teilschicht der Isolationsschicht 12 kann beispielsweise eine Metallschicht auf die Teilschicht aufgebracht werden, welche das elektrische Verbindungselement 13 bildet und damit die Leistungsbauelemente 7 mit den Leiterbahnen 10 elektrisch verbindet. Das elektrische Verbindungselement 13 oberhalb der Leistungsbauelemente 7, also die Metallfläche oberhalb der Leistungsbauelemente 7, kann mit einer hier nicht gezeigten dünnen wärmeleitfähigen, aber elektrisch isolierenden Schicht bedeckt werden, um eine beidseitige Kühlung der Leistungsbauelemente 7 zu ermöglichen.

Anschließen wird eine weitere Teilschicht der Isolierschicht 12 aufgebracht, welche die elektrischen Verbindungselemente 13 sowie die Leistungsbauelemente 7 vollständig bedeckt. Dabei wird eine Oberseite 14 der Leistungseinheit 2 durch eine Oberfläche 15 der Isolierschicht 12 sowie Kontaktflächen 16 der elektrischen Verbindungselemente 13 gebildet. Dazu können die Materialien der Isolierschicht 12 und der elektrischen Verbindungselemente 13 insbesondere bis zu einer einheitlichen Ebene angefüllt werden, sodass die Oberseite 14 der Leistungseinheit 2 als eine ebene Fläche ausgestaltet ist. Eine Unterseite 17 der Leistungseinheit 2 wird durch eine Unterseite des Kühlkörpers 4 gebildet.

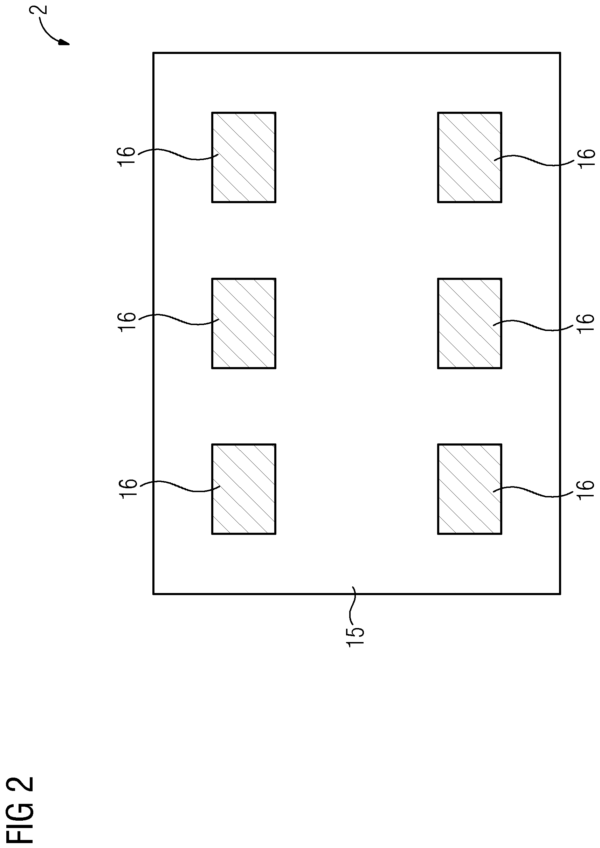

Eine Draufsicht auf die Oberseite 14 der Leistungseinheit 2 ist in FIG 2 gezeigt. Dabei ist ersichtlich, dass die Oberseite 14 der Leistungseinheit 2 als eine ebene, glatte Fläche aufweisend die Kontaktflächen 16 sowie die Oberfläche 15 der Isolierschicht 12 gebildet ist.

Auf der Oberseite 14 der Leistungseinheit 2 wird die Ansteuereinheit 3 angeordnet, welche insbesondere eine elektrische Anbindung für die Leistungseinheit 2 darstellt. Die Ansteuereinheit 3 weist zu den Kontaktflächen 16 korrespondierende Kontaktelemente 18 zum elektrischen und/oder thermischen Kontaktieren der Leistungsbauelemente 7 auf, welche beispielsweise als Kupferblöcke und/oder Druckkontaktelemente und/oder Federkontakte und/oder Kühlstempel ausgebildet sein können. Die Kontaktelemente 18 sind dabei anliegend an den Kontaktflächen 16 angeordnet und dort beispielsweise verlötet oder mittels Federklemmen oder Schraubverbindungen 19 auf die Kontaktflächen 16 aufgepresst.

Die Ansteuereinheit 3 kann beispielsweise eine mehrschichtige Leiterplatte 20 aufweisen. Die Leiterplatte 20 kann ein separates Bauteil sein, welcher beispielsweise über die Schraubverbindungen 19 oder die Federklemmen an die Oberseite 14 der Leistungseinheit 2 angepresst sein. Es kann aber auch sein, dass die Leiterplatte 20 in mehreren Schichten direkt auf die Oberseite 14 der Leistungseinheit 2 abgeschieden ist und somit mit der Oberseite 14 der Leistungseinheit 2 stoffschlüssig verbunden ist. Die einzelnen Schichten der Leiterplatte können beispielsweise sogenannte Prepreg-Schichten sein.

In die Leiterplatte 20 können Bauelemente 21, 22, 23 integriert beziehungsweise eingebettet sein. Das Bauelement 21 kann beispielsweise ein Treiberbaustein sein, welcher über ein weiteres elektrisches Verbindungselement 24 mit dem elektrischen Verbindungselement 13 der Leistungseinheit 2 und damit mit dem Leistungsbauelement 7 elektrisch verbunden sein kann. Das Bauelement 22 kann beispielsweise ein Sensorelement, beispielsweise ein Temperatursensor zur Messung einer Temperatur des Leistungsmoduls 1, sein. Das Bauelement 22 in Form des Temperatursensors kann die ermittelten Messwerte, also hier die Temperatur, beispielsweise drahtlos an eine übergeordnete Steuereinheit übertragen. Das Bauelement 23 kann beispielsweise ein Logikbaustein sein, welcher ebenfalls über ein elektrisches Verbindungselement 24 mit dem elektrischen Verbindungselement 13 der Leistungseinheit 2 verbunden ist.

Dadurch dass innerhalb der Leistungseinheit 2 die Leistungsbauelemente 7 in die Isolierschicht 12 eingebettet und somit voll gekapselt sind und darüber hinaus die Ansteuereinheit 3 mit ihren Kontaktelementen 18 passgenau auf der Oberseite 14 der Leistungseinheit 2 angeordnet ist, wird ein besonders kompaktes, hochintegriertes und intelligentes Leistungsmodul 1 gebildet, welches insbesondere ohne ein Gehäuse betriebsgemäß und bestimmungsgemäß, beispielsweise als Stromrichter, eingesetzt werden kann.

## Patentansprüche

1. Leistungsmodul (1) mit
- einer Leistungseinheit (2), welche einen Kühlkörper (4), zumindest ein auf dem Kühlkörper (4) angeordnetes Leistungsbauelement (7) und eine den Kühlkörper (4) und das zumindest eine Leistungsbauelement (7) bedeckende Isolierschicht (12) aufweist, wobei eine Unterseite (17) der Leistungseinheit (2) durch eine Unterseite des Kühlkörpers (4) gebildet ist und eine Oberseite (14) der Leistungseinheit (2) durch zumindest eine, mit dem zumindest einen Leistungsbauelement (7) thermisch und/oder elektrisch gekoppelte Kontaktfläche (16) sowie eine die zumindest eine Kontaktfläche (16) umgebende Oberfläche (15) der Isolierschicht (12) gebildet ist, und
- einer Ansteuereinheit (3) zum Ansteuern der Leistungseinheit (2), welche zumindest ein, zu der zumindest einen Kontaktfläche (16) der Leistungseinheit (2) korrespondierendes Kontaktelement (18) aufweist, welches durch Anordnen der Ansteuereinheit (3) auf der Oberseite (14) der Leistungseinheit (2) anliegend an der zumindest einen Kontaktfläche (16) der Leistungseinheit (2) zum elektrischen und/oder thermischen Kontaktieren des zumindest einen Leistungsbauelementes (7) angeordnet ist,
- wobei das zumindest eine Leistungsbauelement (7) unmittelbar auf der Oberseite (8) des Kühlkörpers (4) angeordnet ist und durch aufgebrachten Druck auf die Oberfläche (15) der Isolierschicht (12) und/oder auf die zumindest eine Kontaktfläche (16) mittels Federklemmen oder Schraubverbindungen (19) kraftschlüssig mit der Oberseite (8) des Kühlkörpers (4) verbunden ist,
- wobei das zumindest eine Kontaktelement (18) der Ansteuereinheit (3) als ein Kühlelement und/oder als ein elektrisches Druckkontaktelement ausgebildet ist, wobei der Druck zum kraftschlüssigen Verbinden durch die Anordnung des Kühlelements und/oder des Druckkontaktelements auf der zumindest einen Kontaktfläche (16) zum Kontaktieren des zumindest einen Leistungsbauelementes (7) aufgebracht ist,
- wobei die Ansteuereinheit (3) eine Leiterplatte (20) und zumindest ein Bauelement (21, 23) zum Ansteuern des zumindest einen Leistungsbauelementes (7) der Leistungseinheit (2) umfasst,
- wobei die Leiterplatte (20) zumindest zwei Schichten aufweist und das zumindest eine Bauelement (21, 23) zwischen den zumindest zwei Schichten angeordnet ist, und
- wobei eine erste der zumindest zwei Schichten direkt auf die Oberseite (14) der Leistungseinheit (2) abgeschieden ist und mit der Oberseite (14) der Leistungseinheit (2) stoffschlüssig verbunden ist, das zumindest eine Bauelement (21, 23) auf der ersten Schicht angeordnet ist und eine zweite der zumindest zwei Schichten direkt auf der ersten Schicht abgeschieden ist, wobei die zweite Schicht das zumindest eine Bauelement (21, 23) bedeckt.

2. Leistungsmodul (1) nach Anspruch 1, wobei die zumindest eine Kontaktfläche (16) und die Oberfläche (15) der Isolierschicht (12) bündig angeordnet sind und durch die Oberfläche (15) der Isolierschicht (12) und die zumindest eine Kontaktfläche (16) eine ebene Oberseite (14) der Leistungseinheit (2) gebildet ist.

3. Leistungsmodul (1) nach Anspruch 1 oder 2, wobei auf die Oberseite (8) des Kühlkörpers (4) zumindest eine elektrische Leiterbahn (10) aufgebracht ist, die zumindest eine Leiterbahn (10) über ein elektrisches Verbindungselement (13) elektrisch mit dem zumindest einen Leistungsbauelement (7) verbunden ist und das elektrische Verbindungselement (13) von der Isolierschicht (12) bedeckt ist.

4. Leistungsmodul (1) nach einem der vorhergehenden Ansprüche, wobei das zumindest eine Leistungsbauelement (7) innerhalb der Leistungseinheit (2) auf der Oberseite (8) des Kühlkörpers (4) mittels einer Flip-Chip-Technologie aufgebracht ist, bei welcher ein elektrischer und/oder thermischer Anschluss des zumindest einen Leistungsbauelementes (7) direkt auf einer auf der Oberseite (8) des Kühlkörpers (4) aufgebrachten Leiterbahn (10) zum elektrischen Kontaktieren angeordnet ist.

5. Leistungsmodul (1) nach einem der vorhergehenden Ansprüche, wobei zwischen dem zumindest einen Leistungsbauelement (7) und der Oberseite (8) des Kühlkörpers (4) nur eine Verbindungsschicht (9, 11) zum stoffschlüssigen Verbinden des zumindest einen Leistungsbauelementes (7) mit der Oberseite (8) des Kühlkörpers (4) angeordnet ist.

6. Leistungsmodul (1) nach einem der vorhergehenden Ansprüche, wobei der Kühlkörper (4) als eine mit einem elektrisch isolierenden, thermisch leitfähigen Material (6) beschichtete Kühlplatte (5) ausgebildet ist, wobei eine Oberfläche des elektrisch isolierenden, thermisch leitfähigen Materials (6) die Oberseite (8) des Kühlkörpers (4) ausbildet.

7. Leistungsmodul (1) nach einem der vorhergehenden Ansprüche, wobei die Leiterplatte (20) zumindest ein Sensorelement (22) zum Erfassen einer physikalischen Eigenschaft des Leistungsmoduls (1) aufweist.

8. Leistungsmodul (1) nach Anspruch 7, wobei das zumindest eine Sensorelement (22) zwischen den zumindest zwei Schichten angeordnet ist.

9. Leistungsmodul (1) nach Anspruch 8, wobei das zumindest eine Sensorelement (22) auf der ersten Schicht angeordnet ist, wobei die zweite Schicht das zumindest eine Sensorelement (22) bedeckt.

10. Leistungsmodul (1) nach einem der vorhergehenden Ansprüche, wobei die Ansteuereinheit (3) an einer Unterseite der Ansteuereinheit (3) das zumindest eine Kontaktelement (18) aufweist und das zumindest eine Kontaktelement (18) durch die Anordnung der Ansteuereinheit (3) auf der Oberseite (14) der Leistungseinheit (2) anliegend an der zumindest einen Kontaktfläche (16) zum elektrischen und/oder thermischen Kontaktieren des zumindest einen Leistungsbauelementes (7) ausgebildet ist.

11. Leistungsmodul (1) nach einem vorhergehenden Ansprüche, wobei die Ansteuereinheit (3) zumindest eine zu der Kontaktfläche (16) korrespondierende durchgängige Aussparung aufweist, welche raufgrund der Anordnung der Ansteuereinheit (3) auf der Oberseite (14) der Leistungseinheit (2) fluchtend zu der zumindest einen Kontaktfläche (16) angeordnet ist, wobei das zumindest eine Kontaktelement (18) zum Kontaktieren des zumindest einen Leistungsbauelementes (7) in der durchgängigen Aussparung angeordnet ist.

12. Verfahren zum Herstellen eines Leistungsmoduls (1) mit einer Leistungseinheit (2) und einer Ansteuereinheit (3) zum Ansteuern der Leistungseinheit (2), bei welchem auf einem Kühlkörper (4) der Leistungseinheit (2) zumindest ein Leistungsbauelement (7) angeordnet wird und der Kühlkörper (4) und das zumindest eine Leistungsbauelement (7) mit einer Isolierschicht (12) bedeckt werden, wobei eine Unterseite (17) der Leistungseinheit (2) durch eine Unterseite des Kühlkörpers (4) gebildet wird und eine Oberseite (14) der Leistungseinheit (2) durch zumindest eine, mit dem zumindest einen Leistungsbauelement (7) thermisch und/oder elektrisch gekoppelte Kontaktfläche (16) sowie eine die zumindest eine Kontaktfläche (16) umgebende Oberfläche (15) der Isolierschicht (12) gebildet wird, und bei der Ansteuereinheit (3) zumindest ein, zu der zumindest einen Kontaktfläche (16) der Leistungseinheit (2) korrespondierendes Kontaktelement (18) durch Anordnen der Ansteuereinheit (3) auf der Oberseite (14) der Leistungseinheit (2) anliegend an der zumindest einen Kontaktfläche (16) der Leistungseinheit (2) zum elektrischen und/oder thermischen Kontaktieren des zumindest einen Leistungsbauelementes (7) angeordnet wird,
- wobei das zumindest eine Leistungsbauelement (7) unmittelbar auf der Oberseite (8) des Kühlkörpers (4) angeordnet wird und durch Aufbringen eines Druckes auf die Oberfläche (15) der Isolierschicht (12) und/oder auf die zumindest eine Kontaktfläche (16) mittels Federklemmen oder Schraubverbindungen (19) kraftschlüssig mit der Oberseite (8) des Kühlkörpers (4) verbunden wird,
- wobei das zumindest eine Kontaktelement (18) der Ansteuereinheit (3) als ein Kühlelement und/oder als ein elektrisches Druckkontaktelement ausgebildet wird, wobei der Druck zum kraftschlüssigen Verbinden durch das Kühlelement und/oder durch das Druckkontaktelement beim Anordnen auf der zumindest einen Kontaktfläche (16) zum Kontaktieren des zumindest einen Leistungsbauelementes (7) aufgebracht wird,
- wobei die Ansteuereinheit (3) eine Leiterplatte (20) und zumindest ein Bauelement (21, 23) zum Ansteuern des zumindest einen Leistungsbauelementes (7) der Leistungseinheit (2) umfasst,
- wobei die Leiterplatte (20) zumindest zwei Schichten aufweist und das zumindest eine Bauelement (21, 23) zwischen den zumindest zwei Schichten angeordnet wird, und
- wobei eine erste der zumindest zwei Schichten direkt auf die Oberseite (14) der Leistungseinheit (2) abgeschieden wird und mit der Oberseite (14) der Leistungseinheit (2) stoffschlüssig verbunden wird, das zumindest eine Bauelement (21, 23) auf der ersten Schicht angeordnet wird und eine zweite der zumindest zwei Schichten direkt auf der ersten Schicht abgeschieden wird, wobei die zweite Schicht das zumindest eine Bauelement (21, 23) bedeckt.

## Claims

1. Power module (1) comprising
- a power unit (2) having a heat sink (4), at least one power device (7) disposed on the heat sink (4), and an insulating layer (12) covering the heat sink (4) and the at least one power device (7), wherein an underside (17) of the power unit (2) is constituted by an underside of the heat sink (4) and a top side (14) of the power unit (2) is constituted by at least one contact area (16) thermally and/or electrically coupled to the at least one power device (7) and a surface (15) of the insulating layer (12) surrounding the at least one contact area (16), and
- a drive unit (3) for driving the power unit (2), having at least one contact element (18) corresponding to the at least one contact area (16) of the power unit (2), which contact element, by the drive unit (3) being disposed on the top side (14) of the power unit (2), is disposed abutting the at least one contact area (16) of the power unit (2) for making electrical and/or thermal contact with the at least one power device (7),
- wherein the at least one power device (7) is disposed directly on the top side (8) of the heat sink (4) and is force-fit to the top side (8) of the heat sink (4) by applied pressure to the surface (15) of the insulating layer (12) and/or to the at least one contact area (16) by means of spring clips or screwed connections (19),
- wherein the at least one contact element (18) of the drive unit (3) is implemented as a cooling element and/or as an electrical pressure contact element, wherein the force-fitting pressure is applied by the cooling element and/or the pressure contact element being disposed on the at least one contact area (16) for establishing contact with the at least one power device (7),
- wherein the drive unit (3) comprises a circuit board (20) and at least one device (21, 23) for driving the at least one power device (7) of the power unit (2),
- wherein the circuit board (20) has at least two layers and the at least one device (21, 23) is disposed between the at least two layers, and
- wherein a first of the at least two layers is deposited directly onto the top side (14) of the power unit (2) and is bonded to the top side (14) of the power unit (2), the at least one device (21, 23) and/or the at least one sensor element (22) is disposed on the first layer, and a second of the at least two layers is deposited directly on the first layer, wherein the second layer covers the at least one device (21, 23).

2. Power module (1) according to claim 1, wherein the at least one contact area (16) and the surface (15) of the insulating layer (12) are disposed flush and a level top side (14) of the power unit (2) is formed by the surface (15) of the insulating layer (12) and the at least one contact area (16).

3. Power module (1) according to claim 1 or 2, wherein at least one electrical conductor track (10) is applied to the top side (8) of the heat sink (4), the at least one conductor track (10) is electrically connected to the at least one power device (7) via an electrical connecting element (13), and the electrical connecting element (13) is covered by the insulating layer (12).

4. Power module (1) according to one of the preceding claims, wherein the at least one power device (7) inside the power unit (2) is mounted on the top side (8) of the heat sink (4) by means of flip chip technology, whereby an electrical and/or thermal connection of the at least one power device (7) is disposed directly on a conductor track (10) mounted on the top side (8) of the heat sink (4) for making electrical contact.

5. Power module (1) according to one of the preceding claims, wherein only one interconnection layer (9, 11) for bonding the at least one power device (7) to the top side (8) of the heat sink (4) is disposed between the at least one power device (7) and the top side (8) of the heat sink (4).

6. Power module (1) according to one of the preceding claims, wherein the heat sink (4) is implemented as a cooling plate (5) coated with an electrically insulating, thermally conductive material (6), wherein a surface of the electrically insulating, thermally conductive material (6) forms the top side (8) of the heat sink (4).

7. Power module (1) according to one of the preceding claims, wherein the circuit board (20) has at least one sensor element (22) for detecting a physical characteristic of the power module (1).

8. Power module (1) according to claim 7, wherein the at least one sensor element (22) is disposed between the at least two layers.

9. Power module (1) according to claim 8, wherein the at least one sensor element (22) is disposed on the first layer, wherein the second layer covers the at least one sensor element (22).

10. Power module (1) according to one of the preceding claims, wherein the drive unit (3) has the at least one contact element (18) on an underside of the drive unit (3) and, by the drive unit (3) being disposed on the top side (14) of the power unit (2), the at least one contact element (18) is implemented abutting the at least one contact area (16) for making electrical and/or thermal contact with the at least one power device (7).

11. Power module (1) according to one of the preceding claims, wherein the drive unit (3) has at least one continuous gap corresponding to the contact area (16), said gap being disposed flush with the at least one contact area (16) due to the drive unit (3) being disposed on the top side (14) of the power unit (2), wherein the at least one contact element (18) for making contact with the at least one power device (7) is disposed in the continuous gap.

12. Method for producing a power module (1) comprising a power unit (2) and a drive unit (3) for driving the power unit (2), wherein at least one power device (7) is disposed on a heat sink (4) of the power unit (2) and the heat sink (4) and the at least one power device (7) are covered by an insulating layer (12), wherein an underside (17) of the power unit (2) is constituted by an underside of the heat sink (4) and a top side (14) of the power unit (2) is constituted by at least one contact area (16) thermally and/or electrically coupled to the at least one power device (7) and by a surface (15) of the insulating layer (12) surrounding the at least one contact area (16), and, in the case of the drive unit (3), at least one contact element (18) corresponding to the at least one contact area (16) of the power unit (2) is disposed abutting the at least one contact area (16) of the power unit (2) for making electrical and/or thermal contact with the at least one power device (7) by the drive unit (3) being disposed on the top side (14) of the power unit (2),
- wherein the at least one power device (7) is disposed directly on the top side (8) of the heat sink (4) and is force-fit to the top side (8) of the heat sink (4) by applying pressure to the surface (15) of the insulating layer (12) and/or to the at least one contact area (16) by means of spring clips or screwed connections (19),
- wherein the at least one contact element (18) of the drive unit (3) is implemented as a cooling element and/or as an electrical pressure contact element, wherein the force-fitting pressure is applied by the cooling element and/or by the pressure contact element when disposed on the at least one contact area (16) for establishing contact with the at least one power device (7),
- wherein the drive unit (3) comprises a circuit board (20) and at least one device (21, 23) for driving the at least one power device (7) of the power unit (2),
- wherein the circuit board (20) has at least two layers and the at least one device (21, 23) is disposed between the at least two layers, and
- wherein a first of the at least two layers is deposited directly onto the top side (14) of the power unit (2) and is bonded to the top side (14) of the power unit (2), the at least one device (21, 23) and/or the at least one sensor element (22) is disposed on the first layer, and a second of the at least two layers is deposited directly on the first layer, wherein the second layer covers the at least one device (21, 23).

## Revendications

1. Module (1) de puissance, comprenant
- une unité (2) de puissance, qui un puits (4) de chaleur, au moins un composant (7) de puissance disposé sur le puits (4) de chaleur et une couche (12) isolante recouvrant le puits (4) de chaleur et le au moins un composant (7) de puissance, un côté (17) inférieur de l'unité (2) de puissance étant formé par un côté inférieur du puits (4) de chaleur et un côté (14) supérieur de l'unité (2) de puissance par au moins une surface (16) de contact, couplée thermiquement et/ou électriquement avec le au moins un composant (7) de puissance, ainsi que par une surface (15), entourant la au moins surface (16) de contact, de la couche (12) isolante, et
- une unité (3) de commande pour commander l'unité (2) de puissance, qui a au moins un élément (18) de contact, qui correspond à la au moins une surface (16) de contact de l'unité (2) de puissance et qui, par le montage de l'unité (3) de commande sur le côté (14) supérieur de l'unité (2) de puissance, est, en s'appliquant à la au moins une surface (16) de contact de l'unité (2) de puissance, montée pour la mise en contact électrique et/ou thermique du au moins un composant (7) de puissance,
- dans lequel le au moins un composant (7) de puissance est disposé directement sur le côté (8) supérieur du puits (4) de chaleur et, par une pression appliquée sur la surface (15) de la couche (12) isolante et/ou sur la au moins une surface (16) de contact au moyen de pinces à ressort ou de vissages (19), est relié à coopération de force avec le côté (8) supérieur du puits (4) de chaleur,
- dans lequel le au moins un élément (18) de contact de l'unité (3) de commande est constitué sous la forme d'un élément de refroidissement et/ou sous la forme d'un élément électrique de contact par pression, la pression étant, pour la liaison à coopération de force par l'agencement de l'élément de refroidissement et/ou de l'élément de contact par pression, appliquée à la au moins une surface (16) de contact pour la mise en contact du au moins un composant (7) de puissance,
- dans lequel l'unité (3) de commande comprend une plaquette (20) à circuit imprimé et au moins un composant (21, 23) de commande du au moins un composant (7) de puissance de l'unité (2) de puissance,
- dans lequel la plaquette (20) à circuit imprimé a au moins deux couches et le au moins un composant (21, 23) est disposé entre les au moins deux couches, et
- dans lequel une première des au moins deux couches est disposée directement sur le côté (14) supérieur de l'unité (2) de puissance et est reliée à coopération de matière avec le côté (14) supérieur de l'unité (2) de puissance, le au moins un composant (21, 23) est disposé sur la première couche et une deuxième des au moins deux couches est déposée directement sur la première couche, la deuxième couche recouvrant le au moins un composant (21, 23).

2. Module (1) de puissance suivant la revendication 1, dans lequel la au moins une surface (16) de contact et la surface (15) de la couche (12) isolante sont disposées à affleurement et il est formé, par la surface (15) de la couche (12) isolante et par la au moins une surface (16) de contact, un côté (14) supérieur plan de l'unité (2) de puissance.

3. Module (1) de puissance suivant la revendication 1 ou 2, dans lequel il est déposé sur le côté (8) supérieur du puits (4) de chaleur au moins une piste (10) conductrice de l'électricité, la au moins une piste (10) conductrice est connectée électriquement par un élément (13) électrique de liaison au au moins un composant (7) de puissance et l'élément (13) électrique de liaison est recouvert de la couche (12) isolante.

4. Module (1) de puissance suivant l'une des revendications précédentes, dans lequel le au moins un composant (7) de puissance est déposé, au moyen d'une technologie flip-chip, à l'intérieur de l'unité (2) de puissance, sur le côté (8) supérieur du puits (4) de chaleur, technologie par laquelle une connexion électrique et/ou thermique du au moins un composant (7) de puissance est, en vue de la mise en contact électrique, disposée directement sur une piste (10) conductrice déposée sur le côté (8) supérieur du puits (4) de chaleur.

5. Module (1) de puissance suivant l'une des revendications précédentes, dans lequel il est disposé, entre le au moins un composant (7) de puissance et le côté (8) supérieur du puits (4) de chaleur, seulement une couche (9, 11) de liaison pour la liaison à coopération de matière du au moins un composant (7) de puissance au côté (8) supérieur du puits (4) de chaleur.

6. Module (1) de puissance suivant l'une des revendications précédentes, dans lequel le puits (4) de chaleur est constitué sous la forme d'une plaque (5) de refroidissement, isolante électriquement et revêtue d'un matériau (6) conducteur thermiquement, une surface du matériau (6) isolant électriquement et conducteur thermiquement constituant le côté (8) supérieur du puits (4) de chaleur.

7. Module (1) de puissance suivant l'une des revendications précédentes, dans lequel la plaquette (20) à circuit imprimé a au moins un élément (22) de capteur pour détecter une propriété physique du module (1) de puissance.

8. Module (1) de puissance suivant la revendication 7, dans lequel le au moins un élément (22) de capteur est disposé entre les au moins deux couches.

9. Module (1) de puissance suivant la revendication 8, dans lequel le au moins un élément (22) de capteur est disposé sur la première couche, la deuxième couche recouvrant le au moins un élément (22) de capteur.

10. Module (1) de puissance suivant l'une des revendications précédentes, dans lequel l'unité (3) de commande a le au moins un élément (18) de contact sur un côté inférieur de l'unité (3) de commande et le au moins un élément (18) de contact est, pour la mise en contact électrique et/ou thermique du au moins un élément (7) de puissance, constitué par la mise de l'unité (3) de commande sur le côté (14) supérieur de l'unité (2) de puissance, en s'appliquant à la au moins une surface (16) de contact.

11. Module (1) de puissance suivant l'une des revendications précédentes, dans lequel l'unité (3) de commande a au moins un évidement traversant correspondant à la surface (16) de contact et disposé à affleurement avec la au moins une surface (16) de contact, en raison de la mise de l'unité (3) de commande sur le côté (4) supérieur de l'unité (2) de puissance, le au moins un élément (18) de contact étant, pour la mise en contact du au moins un composant (7) de puissance, disposé dans l'évidement traversant.

12. Procédé de fabrication d'un module (1) de puissance ayant une unité (2) de puissance et une unité (13) de commande pour commander l'unité (2) de puissance, dans lequel on met, sur un puits (4) de chaleur de l'unité (2) de puissance, au moins un composant (7) de puissance et on recouvre le puits (4) de chaleur et le au moins un composant (7) de puissance d'une couche (12) isolante, dans lequel on forme un côté (17) inférieur de l'unité (2) de puissance par un côté inférieur du puits (4) de chaleur et on forme un côté (14) supérieur de l'unité (2) de puissance par au moins une surface (16) de contact couplée thermiquement et/ou électriquement au au moins un composant (7) de puissance, ainsi que par une surface (15), entourant la au moins une surface (16) de contact, de la couche (12) isolante, et dans lequel, pour l'unité (3) de commande, on met au moins un élément (18) de contact correspondant à la au moins une surface (16) de contact de l'unité (2) de puissance, en mettant l'unité (3) de commande sur le côté (14) supérieur de l'unité (2) de puissance, en application sur la au moins une surface (16) de contact de l'unité (2) de puissance, pour la mise en contact électrique et/ou thermique du au moins un composant (7) de puissance,
- dans lequel on met le au moins un composant (7) de puissance directement sur le côté (8) supérieur du puits (4) de chaleur et, en appliquant une pression sur la surface (15) de la couche (12) isolante et/ou on le relie à coopération de force avec le côté (8) supérieur du puits (4) de chaleur, sur la au moins une surface (16) de contact, au moyen de pinces à ressort ou de vissages (19),
- dans lequel on constitue le au moins un élément (18) de contact de l'unité (13) de commande sous la forme d'un élément de refroidissement et/ou sous la forme d'un élément électrique à contact par pression, dans lequel on applique, pour la mise en contact du au moins un composant (7) de puissance, lors de la mise sur la au moins une surface (16) de contact, la pression pour la liaison à coopération de force par l'élément de refroidissement et/ou par l'élément de contact par pression,
- dans lequel l'unité (3) de commande comprend une plaquette (20) à circuit imprimé et au moins un composant (21, 23) pour commander le au moins un composant (7) de puissance de l'unité (2) de puissance,
- dans lequel la plaquette (20) à circuit imprimé a au moins deux couches et on met le au moins un composant (21, 23) entre les au moins deux couches, et
- dans lequel on dépose une première des au moins deux couches directement sur le côté (14) supérieur de l'unité (2) de puissance et on la relie à complémentarité de matière au côté (14) supérieur de l'unité (2) de puissance, on met le au moins un composant (21, 23) sur la première couche et on dépose une deuxième des au moins deux couches directement sur la première couche, la deuxième couche recouvrant le au moins un composant (21, 23).
